# EUROPEAN PATENT APPLICATION

(11) **EP 3 460 122 A1**
(43) Date of publication of application: **27.03.2019**
(21) Application number: 17742298.7
(22) Date of filing: 22.05.2017
(51) Int. Cl.: D06M 10/02, D06M 10/06, D06M 11/74, D06M 16/00, D06M 23/16

(54) **TEXTILE SUBSTRATE**

(30) Priority: 20.05.2016 PT 2016109405
(71) Applicant: Universidade de Aveiro, 3810-193 Aveiro (PT); Inesc Microsistemas E Nanotecnologias - Instituto de Engenharia de Sistemas e Computadores para os Microsistemas e as Nanotecnologias, 1000-029 Lisboa (PT)
(72) Inventor: RAMOS JERÓNIMO DIAS ALVES, Helena Cristina, 3810-193 Aveiro (PT); SOARES NEVES, Ana Isabel, 1000-029 Lisboa (PT)
(74) Representative: Patentree
(86) International application number: PCT/IB2017/053006
(87) International publication number: WO 2018/007880

(57) **Abstract**

The present disclosure relates to textile substrates coated with graphene, in particular to synthetic textile substrates comprising a textile polymer and a coating of at least a graphene layer, wherein the textile polymer is selected from a list constituted by: polypropylene, polyethylene, polylactate, nylon, polyamide or combinations thereof. The textile substrates herein disclosed are conductive and antimicrobial textile substrates.

## Description

### Technical field

The present disclosure relates to textile substrates coated with graphene, in particular to synthetic textile substrates coated with at least a graphene layer and with conductive and antimicrobial properties.

### Background

Several approaches have been tried for having textiles with high conductivity, for antistatic textiles, with antimicrobial activity or electronic textiles. For example, several conductive materials have been proposed for incorporating textiles such as carbon nanotubes (DOI: 10.1039/C3NR00320E), polymer nanocomposites (DOI:10.1038/nnano.2009.264), nanowires (DOI: 10.1002/adma.200602802) or ionic liquids (DOI: 10.1002/adma.200802681). More recently, hybrids of carbon/graphene nanotubes through vapour chemical deposition at 1150 °C (DOI: 10.1039/C2NR32735J) or graphene oxide (GO) through electrical potentials or wet-spinnig (DOI: 10.1002/adfm.201300765) for conductive fibres have been used.

Current conductive fibres present features incompatible with textiles, since they are dark/opaque, not very flexible, easily breakable, therefore, incompatible with textile manufacturing.

The different approaches presented illustrate the technical problem to be solved by the present disclosure.

### General description

The present disclosure relates to textile substrates, in particular to synthetic textile substrates polypropylene-, polylactate-, polyethylene- and/or nylon-based, commonly used in the textile industry, said textile substrates being coated with at least a graphene layer, in a water transfer process, at room temperature.

Textile substrate means a base/support with textile characteristics. The textile substrate may be a fibre, a filament, a fabric or a textile. Fibre means synthetic textile yarn composed of a monofilament or multifilaments, of rounded yarn or flattened yarn form. Filament means a textile polymeric yarn. Fabric means textile surface composed of two or more interconnected warp and weft yarn systems.

Coating of textile substrates, in particular of synthetic textile substrates, with at least one graphene layer makes fibres conductive and antimicrobial, in particular antibacterial, while simultaneously maintaining the mechanical and elastic properties of the textile substrates, without modifying the original colour or transparency thereof. The combination of textile substrates with at least a graphene layer allows creating conductive, and antimicrobial textile substrates, in particular antibacterial textile substrates that may be completely integrated in the normal applications of textile substrates, as well as in biomedical applications.

The present disclosure also relates to synthetic textile substrates that may comprise other thermoplastic textiles, fibres and/or fabrics, without restrictions related to roughness and shape, allowing high conductivity and antimicrobial activity.

The applications of the present disclosure may be technical textile substrates and textile substrates incorporating electronic devices, such as medical monitoring sensors, camouflage safety devices, luminescent devices, thermoelectric devices, textile batteries, among others.

The current disclosure aims at substituting conventional conductive fibres facilitating the incorporation of electronic devices into textiles, by combining the conductivity of graphene with ordinary textiles.

The textile substrates resulting from the present disclosure have also shown comprising antimicrobial properties, improving the protective properties and facilitating the required care of textiles.

Despite all approaches described previously in the state of the art, none of said approaches allowed obtaining a synthetic substrate coated with a translucent or transparent material, in particular coated with at least a graphene layer, and resorting to processes compatible with textiles.

The object of the present disclosure is to modify the properties of textile substrates based on thermoplastic polymers such as polypropylene, polyethylene, polylactate, nylon and/or polyamide, making them electrical and simultaneously antimicrobial conductors, maintaining the mechanical characteristics, such as flexibility and lightness; the visual characteristics, such as colour and morphology, of the textile substrates; being that the textile substrate continues to be a safe textile substrate for the further use thereof by any user.

The present disclosure allows creating a surface with at least a transparent and conductive monolayer containing graphene for electrodes in electronic textiles, antistatic, antimicrobes, antiodour applications, shielding. The electrodes in textile applications may provide electrical current, transmit electric signals or act as transducers. The strong adherence of the graphene monolayer to the textile surface and the chemical inertness thereof makes the antimicrobial technology, in particular antibacterial technology, safe and without active ingredients penetrating the skin or being inhaled.

The present disclosure relates to thermoplastic textiles, commonly used in the textile industry, coated with at least a graphene layer, in a water transfer process, at room temperature. The process allows textiles acquiring electrical and antimicrobial properties, maintaining the mechanical, elastic, visual, morphological properties and the safety inherent to textiles.

The disclosure herein presented relates to textile substrates of polypropylene, polylactate, polyethylene and nylon and/or polyamide, commonly used in the textile industry, coated with graphene, in a water transfer process, at room temperature. The graphene coating makes the substrates conductive and simultaneously antibacterial, maintaining the mechanical and elastic properties of the fibres, without modifying the colour or transparency thereof. The combination allows creating conductive, and antibacterial textiles that may be completely integrated in the normal textile applications, as well as in biomedical applications. The potential applications are in technical textiles and in textiles incorporating electronic devices, such as medical monitoring sensors, camouflage safety devices, luminescent devices, thermoelectric devices, textile batteries, among others.

The present disclosure comprises several advantages, namely the reduced thickness thereof, of only one layer (monolayer) or several atomic layers, up to a maximum of 10 atomic layers (multilayer), which allows a very effective electrostatic adhesion of the graphene to the textile substrate; and also the quality control of the graphene monolayer (or multilayers), homogeneous and flawless, which is essential to the conduction efficiency and characteristics such as the transparency and flexibility that the textile substrate disclosed herein presents.

The textile substrate disclosed herein presents unexpected properties, namely the combination of high resistance and simultaneously bactericide and antimicrobial properties.

Graphene monolayer means the graphene with an atomic layer of thickness. Graphene multilayer means several superposed graphene atomic layers, in a maximum of 10 atomic layers.

In an embodiment, the graphene may also be doped with metals, alkali metals, transition metal salts, inorganic acids, in percentages inferior to 10% (w/w).

In an embodiment, from the eleventh graphene layer, the thickness of said layer is relevant, therefore it is no longer considered a 2D material, which also means that it is no longer graphene.

The present disclosure relates to a synthetic textile substrate comprising a textile polymer and a coating of at least a graphene layer,
wherein the textile polymer is selected from a list constituted by: polypropylene, polyethylene, polylactate, nylon, polyamide and combinations thereof,
wherein said textile substrate is conductive and antimicrobial.

In an embodiment, the graphene layer may coat 50-100 % of a surface of the textile substrate, preferably between 80-100 %, depending on the application intended to be given to the textile substrate. For example, the entire textile substrate can be coated for creating antimicrobial textile substrates or antistatic textile substrates, only part of the textile substrate can be coated, in particular for creating electrical circuits or sensors.

In an embodiment, the graphene layer may be a graphene monolayer or a graphene multilayer, being that the graphene multilayer may comprise between 2-10 graphene layers, preferably of 3-7 graphene layers.

In an embodiment, the graphene layer or multilayer may be translucent.

In an embodiment, the coating of graphene layers may further comprise a thermoplastic polymer, an elastomer or mixtures thereof.

In an embodiment, the graphene layer coating may comprise 0.001-5 % (w/w), preferably 0.001-1 % (w/w) of the thermoplastic polymer, or of the elastomer or mixtures thereof, the percentages being determined by Raman spectroscopy.

In an embodiment, said thermoplastic polymer may be selected from the following list: polyvinyl alcohol, polymethylmethacrylate, polyimide, or combinations thereof.

In an embodiment, said elastomer may be selected from the following list: polymethylmethacrylate, polyimide, polydimethylsiloxane or combinations thereof.

In an embodiment, the textile substrate may be obtained by extrusion, polymerisation, spinning, coagulation, melting or drawing.

In an embodiment, the textile substrate may be a textile fibre, a textile monofibre, a multifilament, a fabric or a textile material.

In an embodiment, said textile substrate may further comprise an adhesive, in particular it may comprise a maximum percentage of 10% (w/w) of an adhesive, being that the adhesive may be selected from the following list: polyvinyl acetate, polycarbonate, polyacrylate, polymethacrylate, polystyrene, polyacrylonitrile, polyvinyl chloryde, polybutadiene, polyisoprene, polyether, polyester, silicone, pyrrole, vinyl acetate, polyvinyl alcohol, polyimide, or combinations thereof.

In an embodiment, the graphene layer may be obtained by vapour deposition, in copper foil or obtained by ultrasonification of graphite in aqueous solution.

In an embodiment, the textile substrate herein disclosed may further comprise a doping agent, in particular wherein the doping agent is nitric acid, hydrogen peroxide, caesium fluoride, caesium carbonate, ammonia, ferric chloride, or combinations thereof, is responsible for a synergistic effect wherein an unexpected increase of the resistance and antimicrobial activity of the textile substrate herein disclosed is verified. Preferably, the doping agent may be nitric acid, hydrogen peroxide, caesium fluoride, caesium carbonate or combinations thereof

In an embodiment and for further obtaining better results, the doping agents may be combined, such as for example nitric acid and caesium fluoride, or nitric acid and caesium carbonate, or caesium fluoride and caesium carbonate, may be combined to obtain a textile substrate.

In an embodiment, the textile substrate herein disclosed is polyamide.

In an embodiment, the textile substrate may comprise a resistance between 50-50000 Ohm/sq, preferably between 50-5000 Ohm/sq, more preferably 50-1000 Ohm/sq.

In an embodiment, the textile substrate herein disclosed may comprise a resistance preferably between 100-900 Ohm/sq, even more preferably between 150-450 Ohm/sq.

In an embodiment, the textile substrate may comprise a conductivity at least superior to 100 Siemens per centimetre (S/cm), preferably superior to 450 S/cm, superior to 600 S/cm, more preferably superior to 750 S/cm.

The present disclosure also relates to electronic devices for medical monitoring, camoufflage safety devices, luminescent devices, thermoelectric devices, or textile batteries, comprising the textile substrate herein disclosed.

The present disclosure further relates to the use of the textile substrate herein disclosed as an antimicrobial textile substrate.

Throughout the description and claims the word "comprises" and variations thereof are not intended to exclude other technical features, as other components, or steps. Additional objects, advantages and features of the disclosure will become clear to those skilled in the art upon the examination of the description or may be learned by practice of the invention. The following examples and figures are provided as illustrative means, and are not intended to limit the present disclosure. Besides, the present disclosure covers all possible combinations of particular or preferential embodiments herein described.

### Brief description of the figures

The following figures provide preferred embodiments for illustrating the description and should not be seen as limiting the scope of the disclosure.

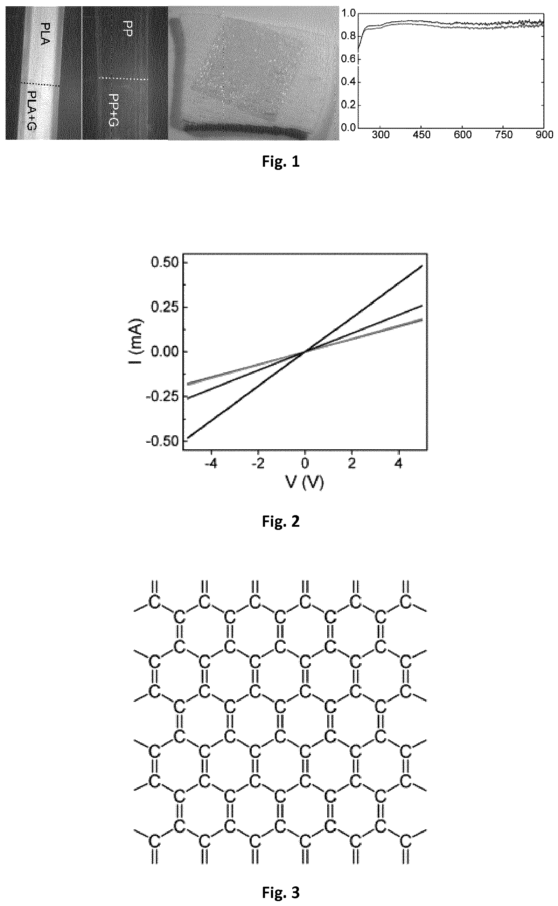

**Figure 1****:** Images of textiles/fibres coated with graphene. Transmittance of the transparent fibre in the visible light region with and without graphene coating.
**Figure 2****:** Conductivity in diverse types of textiles coated with graphene through the described method.
**Figure 3****:** Graphene structure.

### Detailed description

The present disclosure is aimed at the functionalization of textile substrates, in particular synthetic textile substrates, including an active layer in the surface for inserting the electrical conduction and creating an antimicrobial barrier. This active layer in the surface of the textile substrate is at least a graphene layer, and said graphene layer may wholly or partially coat the textile substrate and is capable of continuously inserting high conductivity of the metallic type. The layer is translucent, completely adherent to the textile substrate independently of the morphology and typology, fully maintaining the visual look of the textile substrate. The conductivity of the graphene also inserts antistatic capacity onto the textile substrates, whether they are fibres or fabrics.

Currently there is a growing need for textile substrates with antimicrobial properties, in particular antibacterial properties, namely in healthcare environments, hotel environments, environments with great circulation of persons, as well as airports. This growing need for textile substrates with antimicrobial properties is related to the need for creating textiles that avoid the transmission and/or development of diseases or infections and that reduce or eliminate the formation of body odours while simultaneously maintaining the visual look the textile substrate presents when it is not coated with any graphene layer.

The present disclosure combines a synthetic textile substrate coated with at least a graphene layer, being that said graphene layer is permanently linked to the textile substrate, in particular by covalent bonds, it is capable of withstanding several washing and drying processes without losing its function and it is a transparent/translucent layer, therefore the look and/or colour of the textile substrate remains unchanged.

In an embodiment, the graphene layer or multilayers do(es) not dissolve nor separate(s) from the textile substrate upon consecutive washings with water. It should even be noted that the washing with water is part of the graphene transfer process, to remove other unwanted chemicals from the textile substrate.

In an embodiment, the textile substrate with antimicrobial properties disclosed herein may undergo several washings without losing its properties, in particular it may undergo several washings between 20-100 washings, without losing its properties.

In an embodiment, the graphene layer may be of the type of growth by vapour deposition, on copper foil or alike, or obtained by ultrasonification of graphite in aqueous solution. The aqueous solution may comprise another miscible solvent besides water, in particular alcohols, ketones, esters and the like.

In an embodiment and in case the graphene layer is obtained by vapour growth, the growth sheet was tempered at high temperature under gas atmosphere, being that the composition of said gas atmosphere may include gases such as hydrogen, methane, argon, nitrogen, acetylene. The cooling of the chamber has been done, in particular, under inert atmosphere.

In an embodiment, the graphene layer may further be covered with a protective layer of an elastomer or it may comprise in the composition thereof a polymer such as polymethylmethacrylate, polyimide or polydimethylsiloxane, and said graphene layer may be subjected to a plasma cleaning for removing additional waste.

In an embodiment, the protective layer that may be added to the graphene is only used when the graphene is obtained by vapour growth, said protective layer serving for protecting the graphene layer or multilayers from the plasma cleaning treatment that is carried out afterwards for removing additional waste. The metallic substrate is removed by chemical dissolution in aqueous solution with a percentage of an ionic salt that may be ammonia salts, chlorides, fluorides or others alike. The graphene layer or multilayers with the elastomer remain(s) suspended in aqueous solution, this being transferred to the textile substrate, whether they are fibres or fabrics. The elastomer waste and additional others are removed with a washing with the appropriate solvent, such as ketones, alcohols, esters or the like.

In an embodiment, the synthetic textile substrates may be irradiated with ultraviolet treatment with ozone for improving the adhesion of the graphene layer or multilayers to the textile polymer.

In an embodiment and in case the graphene layer or multilayers is/are obtained by ultrasonification, these are transferred by solution directly to the textile substrates. The ultrasonification is carried out on aqueous medium, with an additional solvent used as dispersive that may be an alcohol, ketone, ester or the like. The concentration of the solution may vary between 1 to 10% (w/v) and be regulated afterwards by solvent evaporation.

In an embodiment, the water composition in the graphene solution may contain at least 75% (v/v) of water, at least 90% (v/v) of water or at least 95% (v/v) of water, being that these concentration variations as a function of the solutions have a direct effect in the electrical resistance of the graphene layer and in the interaction thereof with the textile substrate, that may be hydrophobic or hydrophilic.

In an embodiment, the suitable concentration depends on the application and/or the textile substrate, that is, it depends on the final function of the textile and/or type of textiles. In the case of hydrophobic textiles, the water concentration is more reduced, in particular they may comprise a maximum of 75% (w/v), so as to achieve a more uniform coating. In the case of hydrophilic substrates, solutions with greater percentage of water must be used, in particular at least 90% (w/v) or 95% (w/v), for a more uniform coating. The uniformity of the coating leads to a lower electrical resistance and greater conductivity.

In an embodiment, additives may be added for improving the dispersion emulsion of the graphene, in particular additives selected from the following list: octyl alcohols, ammonia salts, carbon dioxide, silicon dioxide, inorganic acids (e.g.: nitric acid, hypophosphorous acid), sodium salts (e.g.: sodium iodide, sodium chloride), hydrogen peroxide, sodium dodecylbenzene sulphonate, sodium or caesium dodecylbenzene sulphonate, polyaromatic hydrocarbons, polyvinyl alcohol, or polymethylmethacrylate.

In an embodiment and depending on the graphene manufacturing and deposition technique, impurity waste such as catalysts, nucleating agents, insulators, and the like may exist in the formation of the graphene layer/film.

In an embodiment, the graphene composition may be purified before and after the deposition in the textile substrate. The final purity may be superior to 90 %, 95 % or 98%.

In an embodiment, previously referred to purification may be carried out through heating in oxygenated atmosphere or in normal atmosphere, treatment with acids, alcohols or ketones, possibly with ultrasounds, and washings with suitable solvents such as alcohols, ketones, water and the like. The purification process may be used optionally.

In an embodiment, the textile substrates may be of various types of thermoplastic polymers such as polyethylene, polypropylene, polyamide, nylon, polylactate and the like.

In an embodiment, the textile substrate may be in the form of a monofibre, multifilaments or fabric.

In an embodiment, the textile substrate may be formed by any known process such as extrusion, polymerisation, spinning, coagulation, melting, drawing and the like.

The term transparency/translucent refers to a layer with light transmission in the visible region, between 300 nm and 800 nm superior to 85%. The transparent layer/film may present a transmission superior to 90 % or to 93 %. No change of colour of the textile substrate is observed. The transparency may have been tested by comparison of the incident light intensity with the light intensity passing through the material according to established protocols.

In an embodiment, the graphene may be functionalised for facilitating the distribution by the textile substrate as well as for improving the adhesion thereof. Such functionalisation may include the mixture with some polymer, equivalent to the textile polymer of the substrate or another thermoplastic polymer, elastomer or the like.

In an embodiment, the composition of the functionalised textile substrate may include adhesives such as polyvinyl acetate, polycarbonate, polyacrylates, polymethacrylates, polystyrene, polyacrylonitrile, polyvinyl chloryde, polybutadiene, polyisoprene, polyethers, polyesters, silicones, pyrrole, vinyl acetate, polyvinyl alcohols, polyimides, as well as derivatives and mixtures.

In an embodiment, said adhesives may be included in small percentage, for example, inferior to 10% of composition weight. The composition may be used immediately for covering the textile substrate or it may be stored for a period of time for later use.

In an embodiment, the coating of at least one graphene layer may cover the textile polymer entirely or only partially. It may, for example, cover the substrate in a pattern-like form. The pattern will be a continuous pattern so that the current goes through the layer without having to go through the whole surface of the textile substrate.

In an embodiment, the percentage of textile polymer coated with at least a graphene layer may vary in less than 1% to 100%, preferably between 50-100%, even more preferably 80-100%, depending on the application, in particular for antibacterial applications the entire textile surface may be coated, while as for electronic applications the textile substrate may be partially coated/functionalised with graphene.

In an embodiment, the graphene is applied in a monolayer, a monolayer being only a layer of carbon atoms, that is a 2D structure, wherein the thickness that this layer may present is the thickness corresponding to a carbon atom.

In an embodiment, the thickness of the graphene layer may be determined by Raman spectroscopy identifying characteristic vibration signals related to the number of graphene layers, in particular graphene monolayer, graphene bilayer or graphene trilayer.

In an embodiment, the graphene layer may be applied by the transfer method or by solution.

The resistance per sheet (Rs) of the layer is a function of the resistance by area and layer thickness. It is a measure of the electrical resistance in a uniform thin layer/film that may be considered a bidimensional system. The resistance per sheet may be described in ohm units or as per square ohm (Ohm/sq), wherein "sq" is adimensional. Ohm/sq is used exclusively for describing the sheet resistance, and it may be used for differentiating a bidimensional system from a tridimensional system. The resistance per sheet may be measured using four contacts, wherein a current is applied directly between two exterior contacts and the voltage is measured between two interior contacts, located between the exterior contacts, and with the current flowing along the layer plane. The measure of four contacts uses a geometrical correction factor based on the orientation and spacing of the electrodes so as to correct the measure of the contact resistance. The resistivity of the layer/film may be calculated from the resistance of the sheet times the thickness of the layer/film.

In an embodiment, the textile substrate comprising a coating of at least a graphene layer, in particular the fibre or textile covered with graphene, may have a resistance between 300 Ohm/sq-900 Ohm/sq.

In an embodiment, the textile substrate coated with graphene, in particular the fibre or textile covered with graphene may have a resistance inferior to 300 Ohm/sq, inferior to 150 Ohm/sq or inferior to 100 Ohm/sq.

Conductivity (σ) is the measure of the electrical conduction of a material. The conductivity may be measured by applying an electric field differential and monitoring the resulting electrical current. The conductivity is calculated by dividing the current density by the applied electrical field strength. Conductivity is reciprocal of the electrical resistivity, therefore conductivity may be calculated from the resistance per sheet, starting from the inverse of the resistance per sheet and multiplying it by the layer thickness (σ=1/(Rₛ×t)). The conductivity is measured by the method of two contacts, using a unit of source-measure measurement for measuring curves of I/V (I = current, V = voltage).

In an embodiment, the textile substrate coated with graphene as described herein may have conductivity superior to 100 S/cm, greater than 450 S/cm, greater than 600 S/cm or greater than 750 S/cm.

In an embodiment, and optionally, it is possible to deposit one or more layers underneath the graphene conductive layer, in particular it is possible to form a scratch-proof protective layer and/or waterproof layer.

In an embodiment, it is possible to deposit one or more layers covering the graphene conductive layer, in particular it is possible to form a scratch-proof protective layer and/or waterproof layer.

In an embodiment, it is possible to deposit one or more layers in the surface of the textile substrate opposite to the surface comprising the graphene layer, in particular it is possible to form a scratch-proof protective layer and/or waterproof layer.

In an embodiment, the waterproof and scratch-proof layers may be combined and added together on a single deposition.

In an embodiment, following the deposition of at least a carbon layer, the textile substrate, in particular the fibre or textile may be used in an electrical circuit, with a current source applying a voltage, triggering the electrical current circulation. The electrical circuit may include other electrical components, or simply heat the temperature.

Some examples of the application of the present disclosure are now presented.

In an embodiment, the preparation of at least a graphene layer may be carried out as follows: the graphene layer/film may be prepared by growth with vapour chemical deposition, in a reaction chamber with cold walls, using methane and carbon sources and pure copper foil with suitable thickness, in particular with a thickness of 0.025 mm which is, for example, commercially available in Alfa Aesar. The copper foil was previously heated at 1035 °C under H₂ for 10 minutes. The growth was carried out under H₂ and CH₄ for 5 minutes, being afterwards cooled for 10 minutes with Argon. The graphene thickness and quality control was carried out by optical microscopy and Raman spectroscopy.

In an embodiment, the preparation of a graphene solution may be carried out as follows: the graphene solution was prepared by ultrasonification of the graphite in ethanol/water, in particular 1 ethanol: 1 water, in particular 1 g of graphite flakes was added to a solution of 100 ml of ethanol/water, and subject to an ultrasonification, in particular for 2 hours at room temperature. The non-exfoliated graphite flakes were removed by centrifugation, in particular at 1700xg.

In an embodiment, the transfer of graphene film was carried out as follows: the graphene film was protected with a polymethylmethacrylate (PMMA) layer, deposited by centrifugation deposition, in one of the copper sides. The other side was cleaned with argon plasma.

In an embodiment, the copper was eliminated in a solution of ammonia persulphate, in particular a solution of 0.1 M of ammonia persulphate, and the graphene sheet and suspended PPMA in the solution was washed several times with distilled water. The graphene layer or multilayers was/were transferred to the textile substrate, in particular fibre or fabric, and after the adhesion to the textile substrate, it was washed with acetone for removal of the PMMA.

In an embodiment, the transfer of the graphene solution may be carried out as follows: the graphene solution was transferred by deposition by spray pulverisation, with air drying for a few minutes.

In an embodiment, a second deposition of a graphene layer was carried out after drying, using the same method, for increasing the uniformity of the deposition.

In an embodiment, conductivity measures were carried out. The layer/film resistance was measured using a system with tungsten ends and a Keithley 237 measure unit, at room temperature. The layer/film resistivity showed values in the range of 525-980 Ohm/sq, and the layer/film conductivity presented values in the range of 150-430 S/cm.

In an embodiment, the antimicrobial evaluation of the disclosure herein presented was also considered, in particular the antibacterial evaluation. Therefore, the antibacterial evaluation was carried out as follows: after sterilising the samples, these were covered with a bacterial suspension with 6×10⁶ CFU/ml of *Staphylococcus (S.) aureus* or with a suspension with 2×10⁷ CFU/ml of *Escherichia (E.) coli and* incubated for 24h at 37 °C. The bacteria were diluted in a solution of 0.85 % of NaCl and dyed with fluorescent marker.

In an embodiment, textile substrates with graphene and control samples were tested for detecting antibacterial activity. The test and control samples were inoculated with test organisms, in particular *S. aureus* and *E. coli.* After incubation, the bacteria are eluted from the samples by extraction in a quantitative neutralising solution. The number of bacteria present in the liquid was determined and the reduction percentage in the treated samples was calculated.

In an embodiment, the antibacterial textile substrate, in particular the fibres or fabrics, may exhibit a bacterial mortality rate of 99.9% after 24h.

**Table 1: Comparative data of a synthetic textile substrate disclosed herein with one or more graphene coating layers.**

| Synthetic textile substrate | Textile polymer(s) | Resistance without graphene Ω/sq | No. of layers of the graphene coating | Resistance with graphene Ω/sq |
|---|---|---|---|---|
| Sample 1 | Polypropylene | < 1×10¹² | 1 | 1×10³ |
| Sample 2 | Polypropylene | < 1×10¹² | 4 | 6×10² |
| Sample 3 | Polylactate acid | < 1×10¹² | 1 | 2×10³ |
| Sample 4 | Polietileno | < 1×10¹² | 1 | 1×10³ |
| Sample 5 | Nylon | < 1×10¹² | 1 | 2×10³ |
| Sample 6 | Polyamide | < 1×10¹² | 1 | 1×10⁹ |
| Sample 7 | Polyamide | < 1×10⁻¹² | 7 | 1×10⁶ |

**Table 2: Comparative data of the resistance various synthetic textile substrates disclosed herein wherein a doping agent is used.**

| Synthetic textile substrate | Textile polymer(s) | Resistance without graphene Ω/sq | Doping agent | Resistance with graphene Ω/sq |
|---|---|---|---|---|
| Sample 1 | Polyamide | < 1×10¹² | Nitric acid | 2×10⁴ |
| Sample 2 | Polyamide | < 1×10¹² | Hydrogen peroxide | 3×10⁴ |
| Sample 3 | Polyamide | < 1×10¹² | Caesium fluoride | 2×10⁴ |
| Sample 4 | Polyamide | < 1×10¹² | Caesium carbonate | 2×10⁴ |
| Sample 5 | Polyamide | < 1×10¹² | Ammonia | 2×10⁴ |
| Sample 6 | Polyamide | < 1×10¹² | Ferric chloride | 2×10⁵ |

**Table 3: Comparative data of the antimicrobial and bactericide activity of the various synthetic textile substrates herein disclosed.**

| Synthetic textile substrate | Textile polymer(s) | No. of layers of the graphene coating | Dopant | *S. aureus* or *E. coli* | Colony-forming unit (Log CFU) after 24H | Behaviour |
|---|---|---|---|---|---|---|
| Negative control | Polyamide | 0 | 0 | *S. aureus; E. coli* | 5.5 | Non-toxic |
| Sample 1 | Polyamide | 1 | 0 | *S. aureus; E. coli* | 5.5 | Non-toxic |
| Sample 2 | Polyamide | 7 | 0 | *S. aureus; E. coli* | 2 | Bactericide |
| Sample 3 | Polyamide | 7 | HNO₃ | *S. aureus; E. coli* | 2 | Bactericide |
| Sample 4 | Polyamide | 7 | H₂O₂ | *S. aureus; E. coli* | 3 | Bactericide |
| Sample 5 | Polyamide | 7 | CsF | *S. aureus; E. coli* | 5.5 | Non-toxic |
| Sample 6 | Polyamide | 7 | CsCO₃ | *S. aureus; E. coli* | 5.5 | Non-toxic |

In an embodiment, textile substrate, in particular the fibres or fabrics, exhibit a null growth for at least a period of 14 days.

**Table 4: Comparative data of the antimicrobial and bactericide activity of the various synthetic textile substrates herein disclosed.**

| Synthetic textile substrate | Textile polymer(s) | No. of layers of the graphene coating | Dopant | S. aureus or E. coli | Colony-forming unit (Log CFU) after 24H | Behaviour |
|---|---|---|---|---|---|---|
| Negative control | Polyamide | 0 | 0 | Both | 5.5 | Non-toxic |
| Sample 1 | Polyamide | 1 | 0 | Both | 5.5 | Non-toxic |
| Sample 2 | Polyamide | 7 | 0 | Both | 2 | Bactericide |
| Sample 3 | Polyamide | 7 | HNO₃ | Both | 2 | Bactericide |
| Sample 4 | Polyamide | 7 | H₂O₂ | Both | 3 | Bactericide |
| Sample 5 | Polyamide | 7 | CsF | Both | 5.5 | Non-toxic |
| Sample 6 | Polyamide | 7 | CsCO₃ | Both | 5.5 | Non-toxic |

The data presented in the tables of the present document demonstrate the obtention of a synthetic textile substrate described in the present disclosure, wherein said textile substrate is conductive, antimicrobial and bactericide.

The results of the previous tables show that using doping agents improves the behaviour of the textile substrate herein disclosed, making it safer. These results clearly demonstrate that the size, the shape and the superficial polarity (for example with the addition of doping agents) of the graphene-based materials have a strong influence in the antimicrobial and bactericide activity.

Although merely particular embodiments of the present disclosure have been represented and described herein, the skilled person in the art will know how to introduce modifications and replace some technical features with equivalent ones, depending on the requisites of each situation, without leaving the scope of protection defined by the appended claims.

The presented embodiments are combinable. The following claims set out particular embodiments of the disclosure.

## Claims

1. Use of the synthetic textile substrate comprising a textile polymer and a coating of at least a graphene layer,
wherein the textile polymer is selected from a list constituted by: polypropylene, polyethylene, polylactate, nylon, polyamide and combinations thereof,
as a conductor and antimicrobial synthetic textile substrate.

2. Use of the textile substrate according to the previous claim wherein the graphene layer coats 50-100 % of a surface of the textile substrate, preferably between 80-100 %.

3. Use of the textile substrate according to any of the previous claims wherein the graphene layer is a graphene monolayer or a graphene multilayer.

4. Use of the textile substrate according to the previous claim wherein the graphene multilayer comprises between 2-10 graphene layers, preferably 3-7 graphene layers.

5. Use of the textile substrate according to any of the previous claims wherein the graphene layer or the graphene multilayer is translucent.

6. Use of the textile substrate according to any of the previous claims wherein the graphene layer coating further comprises a thermoplastic polymer, an elastomer or, mixtures thereof.

7. Use of the textile substrate according to the previous claim wherein the graphene layer coating comprises 0.001-5 % (w/w), preferably 0.001-1 % (w/w) of the thermoplastic polymer or of the elastomer or of mixtures thereof.

8. Use of the textile substrate according to the previous claims 6-7 wherein the thermoplastic polymer is selected from the following list: polyvinyl alcohol, polymethylmethacrylate, polyimide, or combinations thereof.

9. Use of the textile substrate according to the previous claims 6-7 wherein the elastomer is selected from the following list: polymethylmethacrylate, polyimide, polydimethylsiloxane or combinations thereof.

10. Use of the textile substrate according to any of the previous claims wherein the textile substrate is obtained by extrusion, polymerisation, spinning, coagulation, melting or drawing.

11. Use of the textile substrate according to any of the previous claims wherein the textile substrate is a textile fibre, a textile monofibre, a multifilament or a fabric.

12. Use of the textile substrate according to any of the previous claims wherein the textile substrate further comprises an adhesive.

13. Use of the textile substrate according to the previous claim wherein the textile substrate comprises a maximum percentage of 10 % (w/w) of the adhesive.

14. Use of the textile substrate according to claims 12-13 wherein said adhesive is selected from the following list: polyvinyl acetate, polycarbonate, polyacrylate, polymethacrylate, polystyrene, polyacrylonitrile, polyvinyl chloryde, polybutadiene, polyisoprene, polyether, polyester, silicone, pyrrole, vinyl acetate, polyvinyl alcohol, polyimide, or combinations thereof.

15. Use of the textile substrate according to any of the previous claims wherein the graphene layer is obtained by vapour deposition in copper foil, or obtained by ultrasonification of graphite in aqueous solution.

16. Use of the textile substrate according to any of the previous claims wherein the substrate further comprises a doping agent.

17. Use of the textile substrate according to the previous claim wherein the doping agent is nitric acid, hydrogen peroxide, caesium fluoride, caesium carbonate, ammonia, ferric chloride or combinations thereof.

18. Use of the textile substrate according to the previous claim wherein the doping agent is nitric acid and caesium fluoride or, nitric acid and caesium carbonate or, caesium fluoride and caesium carbonate.

19. Use of the textile substrate according to the previous claim wherein the textile substrate is polyamide.

20. Use of the textile substrate according to any of the previous claims wherein said substrate comprises a resistance between 50-50000 Ohm/sq, preferably between 50-5000 Ohm/sq, more preferably 50-1000 Ohm/sq.

21. Use of the textile substrate according to the previous claim wherein said substrate comprises a resistance between 100-900 Ohm/sq.

22. Use of the textile substrate according to the previous claim wherein said substrate comprises a resistance between 150-450 Ohm/sq.

23. Use of the textile substrate according to the previous claims wherein said substrate comprises a conductivity at least superior to 100 S/cm.

24. Use of the textile substrate according to the previous claim wherein the conductivity of said substrate is superior to 450 S/cm, preferably superior to 600 S/cm, more preferably superior to 750 S/cm.

25. Use of an electronic device for medical monitoring, of a medical device, of a camouflage safety device, of a luminescent device, of a thermoelectric device, or of a battery, comprising the textile substrate disclosed in claims 1-24 as a conductor and antimicrobial textile substrate.
